Europäisches Patentamt

European Patent Office

Office européen des brevets

(19)

(11) Publication number: **0 407 081 A2**

# EUROPEAN PATENT APPLICATION

(12)

(21) Application number: 90306975.5

(22) Date of filing: 26.06.90

(51) Int. Cl.5: **G03F 7/004**

(30) Priority: **05.07.89 GB 8915407**

(43) Date of publication of application:
**09.01.91 Bulletin 91/02**

(84) Designated Contracting States:
**AT BE CH DE DK ES FR GB GR IT LI LU NL SE**

(71) Applicant: **COOKSON GROUP plc**
**130 Wood Street**
**London EC2V 6EQ(GB)**

(72) Inventor: **Campbell, John Stewart**
**Hambleton Camp Road**
**Gerrards Cross, Buckinghamshire(GB)**
Inventor: **Holt, Lyn**
**54 Millwood End**
**Long Hanborough, Oxon(GB)**
Inventor: **Macleod, Norman**
**2 Norbury Way**
**Great Bookham, Surrey KT23 4RY(GB)**
Inventor: **Jolliffe, Barry**
**161 Thorney Leys**
**Witney, Oxon(GB)**

(74) Representative: **Allard, Susan Joyce et al**
**BOULT, WADE & TENNANT, 27 Furnival**
**Streeteet**
**London EC4A 1PQ(GB)**

(54) **Lithoplate production.**

(57) A method of producing a lithoplate by deposition of a copper image onto a substrate characterised by applying a copper salt or a copper compound to the substrate and then irradiating the desired image areas with controlled electromagnetic radiation to decompose the copper salt or copper compound and deposit an image of metallic copper on the substrate.

EP 0 407 081 A2

## LITHOPLATE PRODUCTION

The invention relates to the production of a lithoplate bearing a copper image. In particular it relates to an additive process for depositing a copper image on a lithoplate substrate.

Conventional copper image lithoplates fall into two categories; generally referred to as bimetal and trimetal or multimetal. Bimetal plates consist of a copper image on a substrate of, for example, aluminium or stainless steel. Usually a continuous copper layer is deposited on the substrate and then selectively etched, for example with ferric chloride, to leave the copper image. This is a subtractive process and is now the process which is generally used for copper image lithoplates. Additive processes in which copper is deposited through a stencil to form the image, for example by precipitation of copper from a copperising solution of $CuCl_2$ in isopropanol or water have been employed but are not now commercially used as they are not easily controllable. In a trimetal plate the substrate is again usually aluminium or steel but to this is applied first a continuous layer of copper and then over that a continuous layer of chromium. The chromium is then etched away from the image areas to expose a copper image by a subtractive process.

Lithoplates produced by a subtractive process and having a copper image have been very successful, the background being hydrophilic and the copper oleophilic, although requirements for speed and simple chemical processing have led to the development of photoimageable lithoplates. Photoimageable lithoplates consist of photopolymer on a suitable substrate which is typically anodised aluminium, the desired image being produced by exposure of the photopolymer in the image areas. While such photoimageable are now in common use and have largely replaced copper image lithoplates for short and medium printing runs, copper image lithoplates are still preferred for other applications where long run-life and high resolution are important. Unfortunately, copper image lithoplates made by chemical etching suffer from the drawbacks of higher costs and environmental difficulties compared with photoimageable plates because more time and manpower is needed to produce them and because of the chemical etchants involved.

Thus there is a need to produce lithoplates having a copper image by a simple process which avoids the use of chemical etchants and thereby reduces the cost and environmental problems associated with current processes.

It has been shown by certain workers that under some conditions it is possible to deposit metallic copper onto particular substrates by direct decomposition of copper compounds. Thus, US 2430520 describes the precipitation of metals such as copper on glass by volatilising an organometallic compound in vacuo and then decomposing the compound by contact with a hot glass surface to produce a metal layer. More recently spots, lines or sheet-type films of copper have been deposited from fluorinated organic copper compounds in an evacuated chamber by the application of light from an argon ion laser to a substrate, as described in EP 0135179A. Laser-induced deposit of copper has also recently been achieved from (triethylphosphine) cyclopentadienyl copper (I), Chemistry of Materials Vol. 1 No. 1 1989.

In accordance with the present invention there is provided a method of producing a lithoplate by deposition of a copper image onto a substrate characterised by applying a copper salt or copper compound to the substrate and then irradiating the desired image areas with controlled electromagnetic radiation to decompose the copper salt or copper compound and deposit an image of metallic copper on the substrate.

The use of this method enables the formation of copper image lithoplates without the need for electrolyte or etching systems; instead an additive process in which the copper image is written directly onto the substrate by the controlled electromagnetic radiation is employed. Thus the major wear life and resolution advantages of copper image metal lithoplates are achieved without the problems of chemical etchants. The present invention thereby reduces the cost and environmental problems associated with current processes.

The method of the present invention provides great flexibility in the nature of the lithoplates that can be produced. That is the method can be applied not only to metal substrates that have conventionally been employed with copper etching processes such as steel or to other metal substrates but also to non-metallic substrates thereby enabling the production of copper image lithoplates suitable for widely different applications. Metal substrates which can be employed include zinc; aluminium including grained or roughened aluminium, anodised aluminium and grained anodised aluminium; chromium plated aluminium; steel, including stainless steel; or brass.

One particularly useful substrate is anodised aluminium which has already proved very popular for photoimageable lithoplates because of its grained aluminium oxide surface layer which both provides good wear and is easily made hydrophilic by known techniques. Substrates which are less common at the moment such as polymer paper e.g. polyester paper or laminated composites of polymer on a metal base may also be used. Indeed any material which can exhibit the necessary hydrophilic characteristics, such as

2

glass, ceramic or even certain forms of paper or parchment can be used as the substrate.

By "controlled electromagnetic radiation" is meant radiation which can be directed where desired and can be turned on and off. Preferably well-collimated electromagnetic radiation will be employed which will have good directability as this will enable the writing of more complex images by irradiating only the desired image areas and thus depositing copper only on those areas. A preferred source of controlled electromagnetic radiation is light emitted from a laser, for example an argon ion laser or Nd-Yag. The precise mechanism of decomposition is not known but is believed to be by rapid local heating of the substrate by the beam of radiation and decomposition of the copper salt or copper compound on the hot surface. Pyrolysis of the copper salt or copper compound may also contribute to the deposition of the copper metal on to the substrate. Electromagnetic radiation in the UV region as, for example, emitted by an excimer laser, will also deposit metallic copper from copper salts and copper compounds, although in this case the mechanism is believed to be photolytic. The wavelength of light capable of producing copper can be from Infra-red to UV, provided that adequate energy density to produce copper metal from its salt or compound is present. The electromagnetic radiation thus generally has a wavelength in the range of from 3000nm to 200nm, preferably 1100nm to 400nm.

The copper salt or copper compound may be applied to the surface of the substrate either directly by application of a layer of the copper salt or copper compound, or indirectly by bringing the substrate into contact with the copper salt or copper compound vapour in an enclosed chamber. A layer of the copper salt or copper compound may be applied neat as powder or by precipitation from a solution.

The copper salt or copper compound may be applied in the form of a solution or suspension which also includes a film-forming compound. Preferably an aqueous solution or suspension will be employed in which case the film-forming compound will be water-soluble. Examples of film-forming compounds which may be employed include gum arabic, a carboxymethyl cellulose or other water-soluble cellulose, a dextrin, an alginate, polyvinyl pyrrolidone, polyvinyl alcohol, or a hydrolysed polyvinyl methyl ether-maleic anhydride copolymer and mixtures of two or more thereof.

This particular technique is very convenient as it enables the comparatively easy application of a film of the copper salt or copper compound of controlled thickness and with even distribution of the copper. By controlling the thickness of the layer applied, and knowing the copper concentration of the solution or suspension one can deposit a copper image of desired thickness. Usually the image will be of the order of one or more microns thick; an image about 4 microns thick on a smooth substrate can be used to produce about 1 million impressions before it is worn away, images on grained substrates are more durable.

One drawback with the old techniques for producing additive copper metal plates by precipitation of copper through a stencil was that only a very thin layer of copper could effectively be produced of about 0.1 $\mu$m. Such a thin layer quickly wears away and can produce only a few impressions. Consequently a layer of lacquer was usually applied over the copper image to protect it and it was in fact that lacquer which took the ink and produced the image. The ability of the present invention to produce a thicker layer means that this step in the formation of an additive copper lithoplate can be omitted thus simplifying the process. Of course, if desired lacquer could still be applied on the copper image of lithoplates formed by the method of the present invention to provide an even more durable image.

After irradiation remaining copper salt or copper compound in non-image areas can be easily removed by washing if desired. However, in some cases the remaining copper salt or copper compound may be left on the plate until it is placed on the lithoprinter in which case it will be washed off by the normal flow of liquids over its surface.

Lithoprinting inks are generally dispersions of pigment in a viscous oil vehicle which may contain other additives to modify the working properties of the ink. Thus, the image areas on a lithographic plate must be ink-receptive and water-repellant while the non-image areas must be water-receptive and have a low wettability for ink, the greater the difference in receptivities the better. To help achieve this a desensitiser may be applied to the lithoplate. In the lithographic printing trade "to sensitise" means to make a surface more oleophilic. "To desensitise" on the other hand means either to make a surface more hydrophilic or to prevent a surface which is already relatively hydrophilic from becoming oleophilic. The term "desensitiser" as used herein means a compound or composition which desensitises the background (non-image) areas. Use of a desensitiser thus improves take-up of oil-based ink by the copper image areas which are comparatively oleophilic while reducing the likelihood of take up by the non-image areas. A compound commonly used as a desensitiser is gum arabic.

Formulations which contain not only a desensitiser but also a sensitiser for the copper areas such as phosphoric acid may also be applied to the lithoplate.

While desensitiser may be applied to the lithoplate after formation of the copper image, preferred embodiments of the present invention facilitate application of desensitiser in the same step as the copper

3

salt or copper compound thus further simplifying the lithoplate preparation process.

Thus in one preferred embodiment of the invention the solution or suspension of copper salt or copper compound will further include a desensitiser. Alternatively, in another preferred embodiment of the invention the film-forming polymer itself also acts as a desensitiser thus obviating the need to add a separate desensitiser to the solution or suspension of copper salt or copper compound. Examples of film-forming compounds which are also desensitisers include gum arabic, carboxymethyl celluloses, dextrins, alginates and polyvinyl alcohols.

Of course as is conventionally done for other lithoplates desensitiser may be applied to lithoplates formed by the method of the invention after formation of the copper image to increase protection of the lithoplate during storage even if desensitiser has already been applied in a solution during formation of the image.

Any copper salt or copper compound which can be decomposed by electromagnetic radiation to produce metallic copper can be employed in the method of the invention such as alkyl copper compounds, carbonyl-containing organic copper compounds, fluorinated organic copper compounds or (triethylphosphine) cyclopentadienyl copper (I). Particularly preferred copper salts are copper formate, copper acetate and copper nitrate.

The invention includes a lithographic plate formed by the method of the invention. The invention also includes a lithographic plate precursor comprising a substrate having applied thereon a layer which comprises a solution or suspension of a film-forming compound and a copper salt or copper compound capable of being decomposed to metallic copper by electromagnetic radiation. The invention furthermore includes within its scope a lithographic plate bearing a copper image which has been formed by decomposing a copper salt or copper compound with electromagnetic radiation.

The invention will now be illustrated by the following Examples.

Example 1

A solution of 5.9% copper formate and 20.9% of gum arabic in water was spread onto the surface of a piece of grained and anodised aluminium and dried. An image was then written using an Nd-Yag laser operating in the quasi-continuous mode at a power of 60-100 watts, which reduced the copper compound in the image areas to metallic copper which adhered to the surface of the anodised aluminium. The unreduced copper salt in the non-image areas was washed away with water, to leave an image of deposited copper.

The surface of the lithoplate was then washed with a solution of gum arabic, containing a few percent of phosphoric acid, and air dried. It was then inked. The ink adhered only to the deposited copper, and thus good quality prints of the image were able to be made using the lithoplate.

Example 2

A coating of copper formate and gum arabic, as used in Example 2, was exposed to radiation from an argon ion laser operating at 514nm and a power of 500-600mW. An image of fine lines was then written in the manner as described in Example 1. The copper compound was reduced in the image areas to metallic copper.

Example 3

A solution was formed from

4

|  |  | percent by weight |
|---|---|---|
| copper formate |  | 7.0 |
| gum dextrin |  | 4.6 |
| gum xanthan |  | 0.5 |
| fluorinated surfactant |  | 0.01 |
| water | to | 100.0 |

The solution was spread on to grained and anodised aluminium sheets using K-bars (RK Print-Coat Instruments) Nos. 1, 2, 3, 4 & 8 to give different thicknesses of coating. After drying in a warm current of air, the coated plates were attached to a platform having controllable movement in both horizontal directions beneath an argon ion laser. By moving the platform patterns of lines could be drawn on the aluminium specimens at speeds of 0.3mm/sec to 30mm/sec and at different laser output energy densities.

## Example 4

The solution of Example 3 coated on anodised aluminium was exposed for 5 to 30 seconds to radiation through a mask from a KrF excimer laser at 248nm, pulsing at 1 Hz. Copper images of the mask were obtained at all exposure intervals.

## Example 5

A solution was formed from

|  |  | percent by weight |
|---|---|---|
| copper nitrate |  | 20.0 |
| gum dextrin |  | 3.7 |
| gum xanthan |  | 0.4 |
| fluorinated surfactant |  | 0.05 |
| water | to | 100.0 |

The solution was coated on to anodised aluminium and the dried film exposed to an argon ion laser operating at 514nm, as in Example 3. Fine bright lines of copper were obtained.

## Example 6

The samples from Example 3 were subjected to an accelerated wear-resistance test to simulate the wear due to long runs on a printing press.

The thickness of the films cast with K-bars nos. 1 & 2 were 0.7 and 1.24 $\mu$m respectively, but the

thickness of the copper lines obtained from them was too thin to be measured reliably. As expected these copper lines wore out in the wear test indicating that they would be unlikely to have an extended press life.

The wear resistance of the copper lines drawn from the thicker films varied with the laser power and translational speed of the platform.

Copper lines drawn in films cast with K-bar no. 3 were substantially unbroken and inked up satisfactorily after the wear test and would be expected to have a long press life. A FOGRA pattern, which comprised a pattern of lines of specified and varying width with gaps between the lines also of specific and varying width side by side with the negative image of the pattern, written at 30mm/sec with 350mW also showed good definition after the wear test and also accepted ink satisfactorily.

With the thicker films, from K-bars 3, 4 and 8, the lower energy laser beams deposited insufficient copper at the fastest writing speeds to give long-lasting images. Above 300mW and up to 1.4W satisfactory lines, giving good wear characteristics, could be obtained at writing speeds up to 30mm/sec.

## Claims

1. A method of producing a lithoplate by deposition of a copper image onto a substrate characterised by applying a copper salt or a copper compound to the substrate and then irradiating the desired image areas with controlled electromagnetic radiation to decompose the copper salt or copper compound and deposit an image of metallic copper on the substrate.

2. A method as claimed in claim 1 characterised in that a layer of copper salt or copper compound is applied to the substrate in the form of a solution or suspension which also includes a film-forming compound.

3. A method as claimed in claim 2 characterised in that an aqueous solution or suspension is employed and in that the film-forming compound is water-soluble.

4. A method as claimed in claim 2 or claim 3 characterised in that the film-forming compound comprises gum arabic, a carboxymethyl cellulose or other water-soluble cellulose derivative, a dextrin, an alginate, polyvinylpyrrolidone, polyvinylalcohol or a hydrolysed polymethylether-maleic anhydride copolymer or a mixture of two or more thereof.

5. A method as claimed to any one of claims 2 to 4 characterised in that the solution or suspension further includes a desensitiser.

6. A method as claimed to any one of claims 2 to 4 characterised in that the film-forming compound also acts as a desensitiser.

7. A method as claimed to any one of claims 1 to 6 characterised by applying a desensitiser to the lithoplate after formation of the copper image.

8. A method as claimed in any one of claims 5 to 7 characterised in that the desensitiser or film-forming compound/desensitiser comprises gum arabic, a carboxymethyl cellulose, a dextrin or an alginate, or a mixture of two or more thereof.

9. A method as claimed to any one of claims 1 to 8 characterised in that the copper compound comprises an alkyl copper compound, a carbonyl-containing organic copper compound, a fluorinated organic copper compound or (triethylphosphine) cyclopentadienyl copper (I).

10. A method as claimed to any one of claims 1 to 8 characterised in that the copper salt comprises copper formate, copper acetate or copper nitrate.

11. A method as claimed to any one of the preceding claims wherein the electromagnetic radiation has a wavelength in the range of from 3000nm to 200nm.

12. A method as claimed to any one of claims 1 to 11 characterised in that the electromagnetic radiation is provided by a laser.

13. A lithoplate formed by the method of any one of claims 1 to 12.

14. A lithoplate precursor comprising a substrate having applied thereon a layer which comprises a solution or suspension of a film-forming compound and a copper salt or copper compound capable of being decomposed to metallic copper by electromagnetic radiation.

15. A lithoplate bearing a copper image which has been formed by decomposing a copper salt or copper compound with electromagnetic radiation.